**Europäisches Patentamt**

(19) **European Patent Office**

**Office européen des brevets**

(11) Veröffentlichungsnummer : **0 314 053 B1**

(12) **EUROPÄISCHE PATENTSCHRIFT**

(45) Veröffentlichungstag der Patentschrift :
**09.10.91 Patentblatt 91/41**

(51) Int. Cl.$^5$ : **C25D 5/28, H05B 3/26**

(21) Anmeldenummer : **88117713.3**

(22) Anmeldetag : **25.10.88**

(54) **Vorrichtung zur galvanischen Verstärkung einer Leiterspur auf einer Glasscheibe.**

(30) Priorität : **27.10.87 DE 3736240**

(43) Veröffentlichungstag der Anmeldung :
**03.05.89 Patentblatt 89/18**

(45) Bekanntmachung des Hinweises auf die
Patenterteilung :
**09.10.91 Patentblatt 91/41**

(84) Benannte Vertragsstaaten :
**AT BE CH DE ES FR GB IT LI SE**

(56) Entgegenhaltungen :
**FR-A- 2 441 669**
**GB-A- 1 145 367**

(73) Patentinhaber : **FLACHGLAS
AKTIENGESELLSCHAFT
Otto-Seeling-Promenade 10-14
W-8510 Fürth (DE)**

(72) Erfinder : **Kamps, Karl Heinz
Bortherstrasse 217
W-4134 Rheinberg (DE)**
Erfinder : **Neuendorf, Hans Christoph
Grünstrasse 82 B
W-4230 Wesel (DE)**

(74) Vertreter : **Andrejewski, Walter et al
Patentanwälte Dipl.-Phys. Dr. Walter
Andrejewski Dipl.-Ing. Dr.-Ing. Manfred Honke
Dipl.-Phys. Dr. Karl Gerhard Masch
Theaterplatz 3, Postfach 10 02 54
W-4300 Essen 1 (DE)**

EP 0 314 053 B1

## Beschreibung

Die Erfindung bezieht sich gattungsgemäß auf eine Vorrichtung zur galvanischen Verstärkung einer langgestreckten Leiterspur auf einer Glasscheibe, insbesondere auf einer Kraftfahrzeugscheibe, wobei die Leiterspur als Kathode geschaltet ist. Bei der Leiterspur kann es sich um eine Sammelschienenspur, um eine Heizleiterspur oder um eine Leiterspur anderer Funktion handeln. Sie verläuft im allgemeinen mehr oder weniger gerade und erstreckt sich beispielsweise über die Länge des Randes einer Kraftfahrzeugscheibe.

Bei der bekannten gattungsgemäßen Vorrichtung (JA-OS 60159194 ist die Anode ein Tampon, der mit dem Elektrolyten getränkt wird. Die Anode wird mit der Leiterspur in Berührung gebracht und gleitend über die Leiterspur bewegt. Dazu ist eine Bedienungsperson erforderlich. Diese bekannten Maßnahmen sind zunächst personalaufwendig. Sie lassen sich praktisch nicht mehr automatisieren. Sie befriedigen aber auch in funktioneller Hinsicht nicht : Die Schichtdicke der Verstärkung hängt von der Geschicklichkeit der Bedienungsperson ab, welche die als Tampon ausgeführte Anode führt. Tatsächlich ist das Tampongalvanisieren (vgl. Galvano-Technik 1982, S. 120 ff.) bei ganz anderen Aufgaben, nämlich bei der Durchführung von Reparaturarbeiten an galvanisierten Gegenständen, entstanden.

Für andere Zwecke, d.h. nicht für die galvanische Verstärkung einer langgestreckten Leiterspur auf einer Glasscheibe, kennt man Vorrichtungen, die eine Kammer bilden und auf den zu galvanisierenden Gegenstand aufgesetzt werden (DE-AS 1621143). Hier bilden die Kathoden die Kammerwände. Die Anode ist zumindest in ihrem unteren Teil stabförmig ausgebildet. Das führt zu eigentümlichen Potentialverhältnissen und erheblichen Stromdichtegradienten. Der Elektrolyt wird längs der Anode in die Kammer eingeführt und entsprechend auch wieder zurückgeführt. Er verläßt außerdem die Kammer und läuft neben dem Werkstück ab. Diese bekannten Maßnahmen sind für die Verstärkung einer langgestreckten Leiterspur auf einer Glasscheibe, insbesondere wenn automatisch gearbeitet werden soll, wenig brauchbar.

Bei galvanotechnischen Prozessen muß vor und/oder nach der Abscheidung oder in Zwischenphasen auch eine Spülung mit Wasser oder einer besonderen Spülflüssigkeit durchgeführt werden. Das geschieht regelmäßig in besonderen Apparaten, was insbesondere im Rahmen einer Massenproduktion stört.

Der Erfindung liegt die Aufgabe zugrunde, eine Vorrichtung zur galvanischen Verstärkung einer langgestreckten Leiterspur auf einer Glasscheibe zu schaffen, mit der die galvanische Verstärkung weitgehend automatisch durchgeführt werden kann und bei der sichergestellt ist, daß die Verstärkung überall eine vorgebbare Dicke aufweist. Darüber hinaus soll auch die erforderliche Spülung ohne Schwierigkeiten erfolgen können.

Zur Lösung dieser Aufgabe ist die erfindungsgemäße Vorrichtung gekennzeichnet durch eine auf die glasscheibe mit einem Aufsetzrand dichtend aufsetzbare Galvanisierkammer, die beidseits der Leiterspur einen Distanzstreifen freiläßt, eine Anode in der Galvanisierkammer, die mit einem Abstandzwischenraum über der Leiterspur angeordnet ist und der Leiterspur folgt und Einrichtungen zur Zuführung und Abführung eines Elektrolyten oder einer Spülflüssigkeit, wobei der Elektrolyt auf seinem Wege von der Zuführung zur Abführung den Abstandzwischenraum gleichmäßig durchströmt und wobei der Elektrolyt bzw. die Spülflüssigkeit in abwechselnder Folge die Galvanisierkammer durchströmen. Soll die Dicke überall gleich sein, so erstreckt sich die Anode äquidistant über der Leiterspur. Zur Erzielung unterschiedlicher Dicken kann sie auch schräg angeordnet oder gestuft bzw. abgeschrägt sein. Nach bevorzugter Ausführungsform ist der Aufsetzrand mit einer weichelastischen Dichtung versehen. Die Anode besteht zweckmäßigerweise aus Kohlenstoff, aus einem Metall mit Titanbeschichtung oder aus Edelstahl. — In dem Merkmal, daß die Galvanisierkammer einen Aufsetzrand aufweist, vorzugsweise einen Aufsetzrand mit weichelastischer Dichtung, kommt zum Ausdruck, daß die Galvanisierkammer dichtend auf die Oberfläche der Glasscheibe aufgesetzt wird. Das gilt sowohl für Glasscheiben, die vollkommen eben ausgeführt sind, als auch für Glasscheiben, die einfach oder doppelt gekrümmt sind. Insoweit folgt die Galvanisierkammer in ihrer Ausbildung der Geometrie, die von der Glasscheibe vorgegeben ist. Es versteht sich, daß die kinematische Umkehr unter den Schutz fällt, bei der die zu behandelnden Glasscheiben auf die umgekehrt angeordnete Galvanisierkammer aufgelegt werden.

Erfindungsgemäß wird auf die Glasscheibe im Bereich der zu verstärkenden Leiterspur die Galvanisierkammer aufgesetzt. Das kann automatisch oder weitgehend automatisch geschehen. Das Aufsetzen erfolgt so, daß am Aufsetzrand eine möglichst weitgehende Abdichtung erfolgt. Eine Bewegung der Anode relativ zu der als Kathode geschalteten Leiterspur findet nicht statt. Der Elektrolyt durchströmt auf seinem Weg von der Zuführung zur Abführung den Abstandzwischenraum gleichmäßig. Die Dicke der Verstärkung läßt sich leicht steuern, indem die üblichen, die Galvanotechnik der Zusammenhänge bestimmenden Parameter gesteuert werden, beispielsweise die Ionenkonzentration im Elektrolyten, die Temperatur und die Stromdichte. Da die Anode nicht in Lösung geht, wird der Elektrolyt insoweit nicht störend beeinflußt. Erfindungsgemäß ist sichergestellt, daß die Stromdichte längs der Leiterspur überall vorgebbar ist und keine störenden Gradienten aufweist. Die Spülung ist ohne besondere Manipulation der Glasscheibe möglich und erfordert keinen besonderen Apparat.

2

Im einzelnen bestehen im Rahmen der Erfindung mehrere Möglichkeiten. Eine bevorzugte Ausführungsform der Erfindung ist dadurch gekennzeichnet, daß die Einrichtungen für die Zuführung bzw. Abführung des Elektrolyten bzw. der Spülflüssigkeit einander gegenüberliegend an den Stirnseiten der Galvanisierkammer angeordnet sind. Man kann aber auch die Einrichtungen für die Zuführung bzw. Abführung des Elektrolyten bzw. der Spülflüssigkeit einander gegenüberliegend an den Längsseiten der Galvanisierkammer anordnen. Um auf einfache Weise zu erreichen, daß das Strömungsprofil des Elektrolyten über der Leiterspur überall die gleiche Elektrolytgeschwindigkeit aufweist, wird zweckmäßigerweise, auch bei der Spülung, mit Breitschlitzdüsen gearbeitet. Im übrigen empfiehlt es sich, die erfindungsgemäße Vorrichtung auf die Leiterspur so aufzusetzen, daß der Distanzstreifen zu beiden Seiten der Leiterspur die gleiche Breite besitzt. Das hat zur Folge, daß die Begrenzung der Galvanisierkammer, die als Randbedingung das Strömungsprofil beeinflußt, im Bereich der Leiterspur sich nicht störend auswirkt. Die Strömung kann laminar oder turbulent eingerichtet werden.

Die erreichten Vorteile sind darin zu sehen, daß mit der erfindungsgemäßen Vorrichtung vollautomatisch oder weitgehend automatisch die Verstärkung einer langgestreckten Leiterspur auf einer Glasscheibe erreicht werden kann und zwar bei vorgebbarer Dicke der Verstärkung, die im übrigen auch einfach gesteuert werden kann, sowie mit einfacher Spülung.

Im folgenden wird die Erfindung anhand einer lediglich ein Ausführungsbeispiel darstellenden Zeichnung ausführlicher erläutert. Es zeigen in schematischer Darstellung

Fig. 1    einen Querschnitt durch eine erfindungsgemäße Vorrichtung in Arbeitsstellung,

Fig. 2    in gegenüber der Fig. 1 verkleinertem Maßstab, eine Draufsicht auf den Gegenstand der Fig. 1.

Die in den Figuren dargestellte Vorrichtung dient zu galvanischen Verstärkung einer langgestreckten Leiterspur 1 auf einer Glasscheibe 2, im Ausführungsbeispiel auf einer Kraftfahrzeugscheibe. Die Leiterspur 1 ist als Kathode geschaltet. Es mag sich um die Leiterspur 1 für eine Sammelschiene handeln.

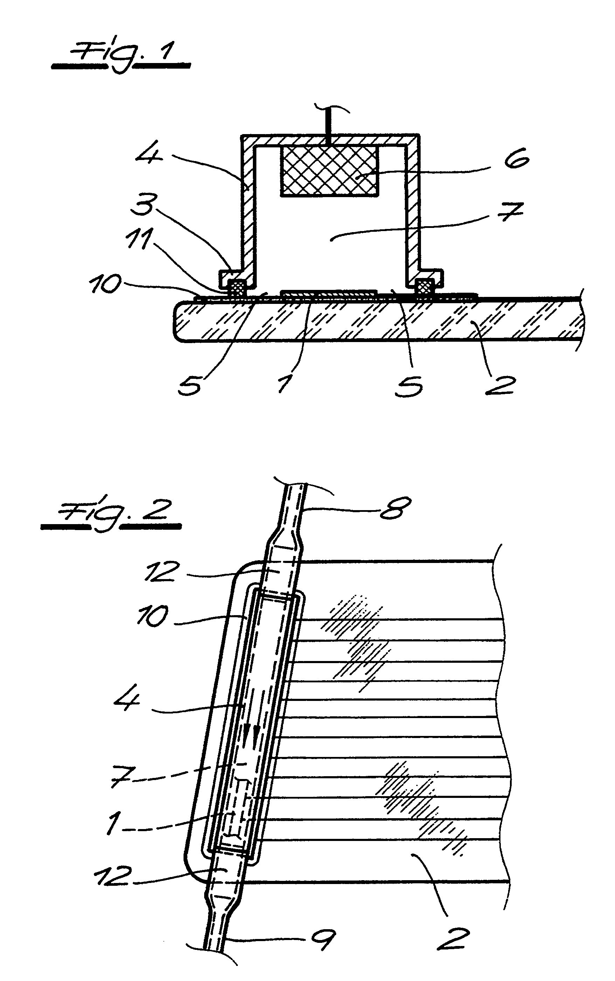

Die Vorrichtung besteht aus einer auf die Glasscheibe 2 mit einem Aufsetzrand 3 dichtend aufsetzbare Galvanisierkammer 4, die beidseits der Leiterspur 1 einen Distanzstreifen 5 freiläßt. Dazu wird insbesondere auf die Fig. 1 verwiesen. Zur Vorrichtung gehört fernerhin eine Anode 6 in der Galvanisierkammer 4, die mit einem Abstandzwischenraum 7 über der Leiterspur 1 äquidistant angeordnet ist und der Leiterspur 1 folgt. Außerdem sind Einrichtungen 8, 9 zur Zuführung und Abführung des Elektrolyten vorgesehen. Die Anordnung ist insgesamt so getroffen, daß der Elektrolyt auf seinem Wege von der Zuführung 8 zur Abführung 9 den Abstandzwischenraum 7 gleichmäßig durchströmt. In Fig. 2 wurden die Geschwindigkeitspfeile eines entsprechenden Strömungsprofils eingezeichnet.

In der Fig. 1 erkennt man, daß sich die Leiterspur 1 im Randbereich einer Kraftfahrzeugscheibe 2 befindet, wobei unter der Leiterspur 1 eine Schicht 10 aus schwarzer Keramik angeordnet ist, die die Leiterspur 1 im eingebauten Zustand der Kraftfahrzeugscheibe kaschiert.

Im Ausführungsbeispiel und nach bevorzugter Ausführungsform der Erfindung ist der Aufsetzrand 3 mit einer weichelastischen Dichtung 11 versehen. Die Anode 6 besteht aus Kohlenstoff.

Die Einrichtungen 8, 9 für die Zuführung bzw. Abführung des Elektrolyten sind im Ausführungsbeispiel einander gegenüberliegend in den Stirnseiten der Galvanisierkammer 4 angeordnet. Sie könnten aber auch an den Längsseiten angeordnet sein. In der Fig. 2 erkennt man, daß mit Breitschlitzdüsen 12 gearbeitet wird. Über die Einrichtungen 8, 9 kann auch die Spülung der Galvanisierkammer erfolgen. Die Einrichtungen 8, 9 werden dazu im Wege des Umgestaltens an einen entsprechenden Spülflüssigkeitsbehälter, dem eine Pumpe zugeordnet ist, angeschlossen. Das Spülen erfolgt vor und/oder nach dem Galvanisieren oder in einer Zwischenstufe, je nach den galvanotechnischen Erfordernissen.

**Patentansprüche**

1. Vorrichtung zur galvanischen Verstärkung einer langgestreckten Leiterspur auf einer Glasscheibe, insbesondere auf einer Kraftfahrzeugscheibe, wobei die Leiterspur als Kathode geschaltet ist, gekennzeichnet durch

eine auf die Glasscheibe (2) mit einem Aufsetzrand (3) dichtend aufsetzbare Galvanisierkammer (4), die beidseits der Leiterspur (1) einen Distanzstreifen (5) freiläßt,

eine Anode (6) in der Galvanisierkammer (4), die sich nicht verbraucht und die mit einem Abstandzwischenraum (7) über der Leiterspur (1) angeordnet ist und der Leiterspur (1) folgt und

Einrichtungen (8, 9) zur Zuführung und Abführung eines Elektrolyten oder einer Spülflüssigkeit,

wobei der Elektrolyt auf seinem Wege von der Zuführung (8) zur Abführung (9) den Abstandzwischenraum (7) gleichmäßig durchströmt und wobei der Elektrolyt bzw. die Spülflüssigkeit in abwechselnder Folge die Galvanisierkammer durchströmen.

2. Vorrichtung nach Anspruch 1, dadurch gekennzeichnet, daß der Aufsetzrand (3) mit einer weichelastischen Dichtung (11) versehen ist.

3. Vorrichtung nach einem der Ansprüche 1 oder 2, dadurch gekennzeichnet, daß die Anode (6) aus Kohlenstoff, aus einem Metall mit Titanbeschichtung oder aus Edelstahl aufgebaut ist.

4. Vorrichtung nach einem der Ansprüche 1 bis 3, dadurch gekennzeichnet, daß die Einrichtungen (8, 9) für die Zuführung bzw. Abführung des Elektrolyten bzw. der Spülfüssigkeit einander gegenüberliegend an den Stirnseiten der Galvanisierkammer (4) angeordnet sind.

5. Vorrichtung nach einem der Ansprüche 1 bis 3, dadurch gekennzeichnet, daß die Einrichtungen (8, 9) für die Zuführung bzw. Abführung des Elektrolyten bzw. der Spülfüssigkeit einander gegenüberliegend an den Längsseiten der Galvanisierkammer (4) angeordnet sind.

6. Vorrichtung nach einem der Ansprüche 1 bis 5, dadurch gekennzeichnet, daß die Einrichtungen (8, 9) für die Zuführung bzw. Abführung des Elektrolyten bzw. der Spülflüssigkeit als Breitschlitzdüsen (12) ausgeführt sind, die sich über die Breite bzw. Länge der Galvanisierkammer (4) erstrecken.

## Claims

1. A device for thickening by electroplating of an extended conductive track on a pane of glass, particularly on a motor vehicle window, in which the conductive track is connected as the cathode, *characterized by* :
an electroplating chamber (4) with a setting-down rim (3) that can be set down to form a seal on the pane of glass (2), and that leaves a spacing strip (5) free on either side of the conductive track (1),
an anode (6) in the electroplating chamber (4) that is not consumed, that is positioned above the conductive track (1) with a clearance spacing (7) and that follows the conductive track (1), and
equipments (8, 9) for the supply and removal of an electrolyte or a washing liquid,
in which the electrolyte flows uniformly through the clearance spacing (7) on its way from the supply point (8) to the removal point (9) and in which the electrolyte and the washing liquid flow through the electroplating chamber in alternate succession.

2. A device according to Claim 1, *characterized in that* the setting-down rim (3) is provided with a soft elastic seal (11).

3. A device according to one of Claims 1 or 2, *characterized in that* the anode (6) is constructed of carbon, of a metal with a titanium coating or of alloy steel.

4. A device according to one of Claims 1 to 3, *characterized in that* the equipments (8, 9) for the supply or removal of the electrolyte or the washing liquid are arranged opposite to one another on the end faces of the electroplating chamber (4).

5. A device according to one of Claims 1 to 3, *characterized in that* the equipments (8, 9) for the supply or removal of the electrolyte or the washing liquid are arranged opposite to one another on the longitudinal faces of the electroplating chamber (4).

6. A device according to one of Claims 1 to 5, *characterized in that* the equipments (8, 9) for the supply or removal of the electrolyte or the washing liquid are constructed as wide slot nozzles (12) that extend across the width or the length of the electroplating chamber (4).

## Revendications

1. Dispositif pour le renforcement par électro-diposition d'une ligne conductrice allongée sur une vitre, en particulier sur une vitre de véhicule automobile, la ligne conductrice étant montée en cathode, **caractérisé par le fait** qu'il comprend une chambre galvanoplastique (4) posée de manière étanche avec un bord de pose (3) sur la vitre (2) et laissant libre de part et d'autre de la ligne conductrice (1) une bande d'écartement (5), une anode (6) à l'intérieur de la chambre galvanoplastique (4) qui ne s'use pas et est disposée avec un intervalle d'espacement (7) au-dessus de la ligne conductrice (1) et qui suit ladite ligne conductrice (1), et des dispositifs (8, 9) pour l'amenée et l'évacuation d'un électrolyte ou d'un liquide de rinçage, l'électrolyte traversant de manière uniforme l'intervalle d'espacement (7) sur sa trajectoire de l'amenée (8) à l'évacuation (9) et l'électrolyte ou le liquide de rinçage traversant alternativement la chambre galvanoplastique.

2. Dispositif selon la revendication 1, caractérisé par le fait que le bord de pose (3) est muni d'un joint d'étanchéité (11) souple et élastique.

3. Dispositif selon l'une des revendications 1 ou 2, caractérisé par le fait que l'anode (6) est constituée de carbone, d'un métal avec revêtement de titane ou d'acier fin.

4. Dispositif selon l'une des revendications 1 à 3, caractérisé par le fait que les dispositifs (8, 9) pour l'amenée et respectivement l'évacuation de l'électrolyte et respectivement le liquide de rinçage sont placés en face l'un de l'autre sur les faces frontales de la chambre galvanoplastique (4).

5. Dispositif selon l'une des revendications 1 à 3, caractérisé par le fait que les dispositifs (8, 9) pour l'amenée et respectivement l'évacuation de l'électrolyte et respectivement du liquide de rinçage sont placés en face l'un de l'autre sur les grands côtés de la chambre galvanoplastique (4).

6. Dispositif selon l'une des revendications 1 à 5, caractérisé par le fait que les dispositifs (8, 9) pour l'amenée et respectivement l'évacuation de l'électrolyte et respectivement du liquide de rinçage sont conformés en buses plates (12) qui s'étendent sur la largeur et respectivement sur la longueur de la chambre galvanoplastique (4).

Fig. 1

Fig. 2